# EUROPEAN PATENT SPECIFICATION

(11) **EP 3 439 019 B1**
(45) Date of publication and mention of the grant of the patent: **06.07.2022**
(21) Application number: 17773909.1
(22) Date of filing: 23.02.2017
(51) Int. Cl.: H01L 33/40, H01L 21/28, H01L 29/40, H01L 33/32

(54) **N-TYPE ELECTRODE, METHOD FOR MANUFACTURING N-TYPE ELECTRODE, AND N-TYPE LAMINATED STRUCTURE WHEREIN N-TYPE ELECTRODE IS PROVIDED ON N-TYPE GROUP III NITRIDE SINGLE CRYSTAL LAYER**
N-TYP-ELEKTRODE, VERFAHREN ZUR HERSTELLUNG DER N-TYP-ELEKTRODE UND N-TYP-LAMINATSTRUKTUR, IN DER DIE N-TYP-ELEKTRODE AUF EINER N-TYP-GRUPPE-III-NITRID-EINZELKRISTALLSCHICHT BEREITGESTELLT IST
ÉLECTRODE DU TYPE N, PROCÉDÉ DE FABRICATION D'ÉLECTRODE DU TYPE N, ET STRUCTURE STRATIFIÉE DU TYPE N DANS LAQUELLE UNE ÉLECTRODE DU TYPE N EST DISPOSÉE SUR UNE COUCHE MONOCRISTALLINE DE NITRURE DU GROUPE III DU TYPE N

(30) Priority: 30.03.2016 JP 2016068866
(43) Date of publication of application: 06.02.2019
(73) Proprietor: Stanley Electric Co., Ltd., Meguro-ku Tokyo 153-8636 (JP)
(72) Inventor: MISHIMA, Yu, Shunan-shi Yamaguchi 745-8648 (JP); SATOU, Tomoaki, Shunan-shi Yamaguchi 745-8648 (JP); OBATA, Toshiyuki, Shunan-shi Yamaguchi 745-8648 (JP)
(74) Representative: Canzler & Bergmeier Patentanwälte Partnerschaft mbB
(86) International application number: PCT/JP2017/006854
(87) International publication number: WO 2017/169364

(56) References cited:
- WO-A1-03/023838
- JP-A- H10 200 161
- JP-A- 2006 261 624
- JP-A- 2009 188 215
- JP-A- 2012 182 211
- KR-A- 20070 068 537
- US-B2- 8 659 714
- HOU WENTING ET AL: "Effects of oxygen thermal annealing treatment on formation of ohmic contacts to n-GaN", APPLIED PHYSICS LETTERS, A I P PUBLISHING LLC, US, vol. 101, no. 24, 10 December 2012 (2012-12-10), pages 242105-242105, XP012168377, ISSN: 0003-6951, DOI: 10.1063/1.4769965 [retrieved on 2012-12-11]
- LUTHER B P ET AL: "INVESTIGATION OF THE MECHANISM FOR OHMIC CONTACT FORMATION IN AL AND TI/AI CONTACTS TO N-TYPE GAN", APPLIED PHYSICS LETTERS, A I P PUBLISHING LLC, US, vol. 70, no. 1, 6 January 1997 (1997-01-06), pages 57-59, XP000680560, ISSN: 0003-6951, DOI: 10.1063/1.119305

## Description

### TECHNICAL FIELD

The present invention relates to a novel n-type electrode, a method for manufacturing the n-type electrode, and an n-type laminated structure having the n-type electrode on an n-type group III nitride single crystal layer. More specifically, the invention relates to a novel n-type electrode containing oxygen atoms in a specific amount and further to a method for manufacturing the n-type electrode and an n-type laminated structure having the n-type electrode on an n-type group III nitride single crystal layer.

The n-type electrode and n-type laminated structure of the invention can be applied to a semiconductor wafer (chip) and to a laser diode, a light emitting diode, and the like.

### BACKGROUND ART

A relatively favorable contact resistance value is obtained between an electrode and an n-type GaN layer, which is a group III nitride semiconductor, by the configuration of metals such as Ti/Al/Au. For example, a method for forming an n-type contact electrode is disclosed in which Ti and Al are sequentially formed on a GaN layer, which is an n-type semiconductor layer, and a metal having higher melting point than Al is laminated thereon as an n-type contact electrode (for example, see Patent Document 1). In Patent Document 1, Au, Ti, Ni, Pt, W, Mo, Ta, Cu and the like are mentioned as a metal having higher melting point than Al, and it is indicated that Au exhibiting high bonding property particularly with Ti and Al is favorable. These methods relate to an n-type electrode formed on an n-type GaN layer.

In addition, the present inventors have proposed a method for forming an n-type electrode on an n-type group III nitride single crystal layer containing Al. In order to realize a light emitting diode and a laser diode which emit light in deep ultraviolet region having a wavelength of 300 nm or less and have high optical output, an n-type semiconductor layer (n-type group III nitride single crystal layer) containing a group III nitride including Al is required. The present inventors have proposed a method for forming an n-type electrode having low contact resistance by preventing oxidation of Al in the n-type electrode formed on an n-type group III nitride single crystal layer containing Al although it is a hypothesis. Specifically, it is reported that the voltage rise caused by the n-type electrode can be lowered by forming a layer containing Ti on an n-type nitride single crystal layer, then subjecting the layer to a heat treatment at a predetermined temperature, further forming a layer containing Al thereon as a second electrode layer after the heat treatment, and then subjecting the resultant to a heat treatment again (see Patent Document 2). Finally, Patent Document 3 discloses the features of the preamble of independent device claim 1 and independent method claim 6. Said document discloses a light emitting device including a light emitting structure comprising a first conductivity type semiconductor layer, an active layer and a second conductivity type semiconductor layer. A first ohmic layer and a first electrode are provided on the first conductivity type semiconductor layer, and a second electrode is provided on the second conductivity type semiconductor layer. A contact area between the first conductivity type semiconductor layer and the first ohmic layer comprises oxygen at 5% or more of an atomic ratio or nitrogen at 50% or more of an atomic ratio.

### CITATION LIST

### PATENT DOCUMENT

Patent Document 1: JP 7-221103 A
Patent Document 2: WO 2011/078252 A
Patent Document 3: US 8 659 714 B2

### SUMMARY OF THE INVENTION

### PROBLEM TO BE SOLVED BY THE INVENTION

According to the conventional methods described above, an n-type contact electrode having a favorable contact resistance value is obtained in the case of an n-type GaN layer and an n-type group III nitride single crystal layer containing Al.

However, the semiconductor devices containing group III nitrides will be widely used in the future, particularly, in order to widely use the semiconductor device having an n-type group III nitride single crystal layer containing Al, it is desired to further lower the contact resistance value between the n-type group III nitride single crystal layer and the n-type electrode. Namely, it is required to apply higher current in order to realize a semiconductor device having higher output in the future. In that case, the voltage value also increases, and it is thus required to further lower the contact resistance in order to obtain a semiconductor device having excellent durability.

Accordingly, an object of the invention is to provide an n-type electrode, by which the contact resistance value between the n-type group III nitride single crystal layer and the n-type electrode can be further lowered, and a method for manufacturing the n-type electrode. Another object of the invention is to provide an n-type laminated structure having lowered contact resistance value.

### MEANS FOR SOLVING PROBLEM

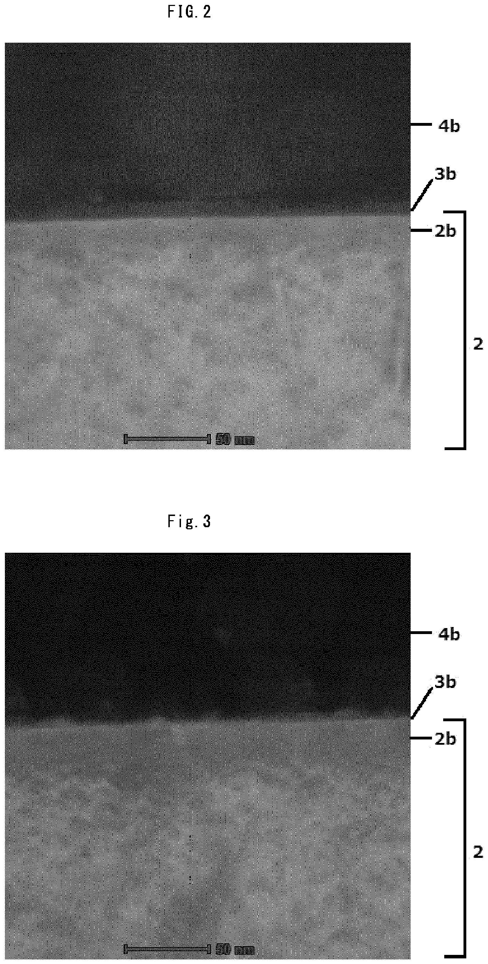

In order to solve the above problems, the present inventors have conducted intensive investigations. As a result, it has been found out that the contact resistance of the n-type laminated structure is influenced by the thickness of the damaged layer (a portion at which a change in composition due to detachment of a part of group III atoms constituting the single crystal is observed. See Fig. 3) occurred in the n-type group III nitride single crystal layer. Furthermore, it has been found out that this damaged layer is generated by the heat treatment when forming the n-type electrode. Moreover, the heat treatment conditions have been extensively investigated in order to reduce the thickness of this damaged layer, and as a result, it has been found out that the above problems can be solved by forming an n-type electrode so as to contain oxygen atoms at a specific concentration, whereby the invention has been completed.

In other words, a first aspect of the invention relates to an n-type electrode to be formed on an n-type group III nitride single crystal layer, which includes a first electrode layer to be formed on the n-type group III nitride single crystal layer and a second electrode layer formed on the first electrode layer and in which at least the first electrode layer contains nitrogen atoms and oxygen atoms and an atomic ratio of the oxygen atoms to the nitrogen atoms is 0.2 or more and 2.0 or less.

A second aspect of the invention relates to an n-type laminated structure having the n-type electrode according to the first aspect of the invention on an n-type nitride single crystal layer.

A third aspect of the invention relates to a method for forming an n-type electrode on an n-type group III nitride single crystal layer, comprising a step of forming a metal layer to be the n-type electrode including a step of forming a first metal layer on the n-type group III nitride single crystal layer,
a step of forming a first electrode layer by performing a heat treatment in a mixed gas atmosphere containing an oxygen gas and an inert gas after the formation of the first metal layer, and
a step of forming a second electrode layer on the first electrode layer, wherein the heat treatment performed after formation of the first metal layer in the step of forming the first electrode layer is a first heat treatment step of performing a heat treatment at a temperature of 800°C or more and 1200°C or less in a mixed gas atmosphere having a proportion of oxygen gas of from 0.1 to 10 vol%.

In the invention, oxygen atoms is intentionally introduced into the n-type electrode in a specific concentration range. In the prior art as described in Patent Documents 1 and 2, it has been known that the bonding strength between the metal layers decreases and the resistance value increases when the metal layer of the n-type electrode is oxidized. Hence, it has not been practiced in the prior art to intentionally introduce oxygen atoms in the n-type electrode. On the contrary, the invention has been completed by finding out that an n-type electrode exhibiting excellent performance is obtained when the n-type electrode contains oxygen atoms at a specific concentration, and the present invention is completely different from the prior art in technical concept.

### EFFECT OF THE INVENTION

According to the invention, it is possible to further lower the contact resistance of the n-type laminated structure having the n-type electrode on the n-type group III nitride single crystal layer. The invention is excellent since it is possible to lower the contact resistance value particularly even in the case of including an n-type group III nitride single crystal layer containing Al having a high resistance value.

According to the invention, it is possible to diminish detachment of the atoms constituting the crystals in the n-type group III nitride single crystal layer, which is likely to occur at the time of formation of the n-type electrode. As a result, it is possible to decrease the thickness of the damaged layer from which atoms are detached and to lower the contact resistance.

### BRIEF DESCRIPTION OF DRAWINGS

- **Fig. 1**: is a flow chart when forming the n-type electrode;
- **Fig. 2**: is a scanning transmission electron microscope (STEM)-high-angle annular dark-field (HAADF) image of the interface between the n-type group III nitride single crystal layer and the n-type electrode in Example 2; and
- **Fig. 3**: is a STEM-HAADF image of the interface between the n-type single crystal layer and the n-type electrode in Comparative Example 1.

### MODE FOR CARRYING OUT THE INVENTION

Hereinafter, embodiments of the invention will be described with reference to the drawings as appropriate. However, the n-type laminated structure (a structure having the n-type electrode on the n-type group III nitride single crystal layer) described below is an example to illustrate the technical idea of the invention but the invention is not limited thereto. For example, the dimensions, materials, shapes and relative arrangement of the constituent elements described below are not intended to limit the scope of the invention only thereto but are merely explanatory examples unless otherwise stated. It should be noted that the sizes and positional relations of the members illustrated in the respective drawings may be exaggerated sometimes in order to clarify the description.

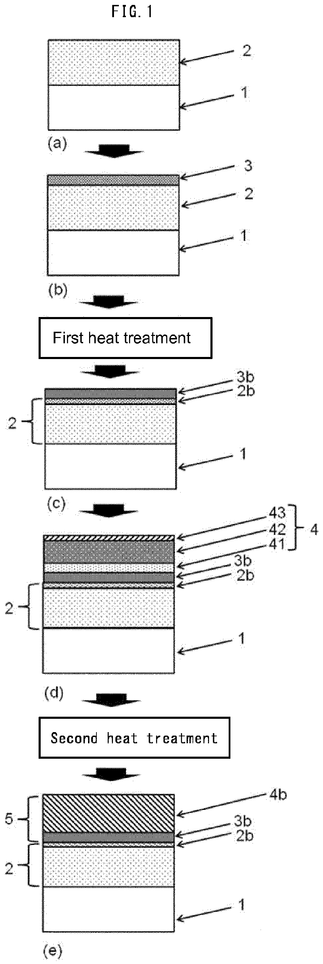

A schematic diagram (an example) of the n-type laminated structure in which the n-type electrode 5 is formed is illustrated in Fig. 1(e). Hereinafter, non-limiting typical examples of these will be described. The n-type electrode 5 of the invention is formed on the n-type group III nitride single crystal layer. First, the n-type group III nitride single crystal layer will be described.

### (n-type group III nitride single crystal layer)

In the invention, the n-type group III nitride single crystal layer can be manufactured by a known method. In the invention, a group III nitride means one satisfying the composition represented by a general formula Al_{A}In_{B}Ga_{1-A-B}N (where A, B and C satisfy 0 ≤ A ≤ 1.0, 0 ≤ B ≤ 1.0, and 0 ≤ A + B ≤ 1.0). In order to convert a group III nitride into an n-type, it is required to dope an n-type impurity (donor) such as silicon (Si) or germanium (Ge) at usually from 1 × 10¹⁷ to 5 × 10²⁰ (atoms/cm³) and preferably from 1 × 10¹⁸ to 5 × 10¹⁹ (atoms/cm³), but the concentrations of these impurities are not considered in the above composition formula. The crystallinity and contact characteristics of the n-type group III nitride single crystal layer are improved by setting the concentration of impurity in the above range. Such an n-type group III nitride single crystal layer can be manufactured by a MOCVD method. The n-type group III nitride single crystal layer may be a single layer having the above composition range, may be formed of a plurality of layers having different compositions, or may be a graded composition layer of which the composition continuously changes.

Figure 1 shows a flow chart of a step for forming the n-type electrode of the invention. The description will be given based on this drawing. The composition and configuration of an n-type group III nitride single crystal layer 2 may be appropriately determined depending on the use. For example, the n-type group III nitride single crystal layer 2 may be formed on a single crystal substrate 1 such as a sapphire substrate or a laminate in which one or more group III nitride single crystal layers having different compositions are formed on the substrate 1.

The thicknesses of the substrate 1 and the n-type group III nitride single crystal layer 2 may be appropriately determined depending on the intended use. The thickness of the n-type group III nitride single crystal layer 2 is usually from 0.5 to 5.0 µm. In addition, the thickness of a damaged layer 2b generated by a heat treatment is preferably 25 nm or less and more preferably 20 nm or less. It is considered that this damaged layer 2b is generated by a heat treatment, and it is most preferable that the damaged layer 2b does not exist. Hence, the most preferable thickness of the damaged layer 2b is 0 µm.

Such an n-type group III nitride single crystal layer 2 can be formed, for example, by a metal organic chemical vapor deposition method (MOCVD method). Specifically, the n-type group III nitride single crystal layer 2 can be formed by supplying a group III raw material gas, for example, a gas of an organic metal such as trimethylaluminum and a nitrogen source gas, for example, a raw material gas such as ammonia gas onto the single crystal substrate 1 or the laminate by using a commercially available apparatus. As the conditions for forming the n-type group III nitride single crystal layer 2 by the MOCVD method, a known method can be adopted.

In the invention, the n-type group III nitride single crystal layer 2 can be formed in accordance with the method described above. The n-type group III nitride single crystal layer 2 is not particularly limited as far as that contains the group III nitride single crystal represented by the composition described above. Hence, the n-type group III nitride single crystal layer 2 may be a GaN layer. However, the method of the invention exerts an excellent effect particularly when the n-type group III nitride single crystal layer 2 contains a group III nitride single crystal containing Al, and among these, particularly preferred n-type group III nitride single crystal layer 2 contains a group III nitride single crystal satisfying the composition represented by AlxInyGazN (x, y, z are rational numbers satisfying 0 < x ≤ 1.0, 0 ≤ y ≤ 0.1, and 0 ≤ z < 1.0, and x + y + z = 1.0).

The electron affinity of such n-type group III nitride single crystal layer 2 containing Al decreases as the Al content rate increases. At this time, the Schottky barrier when being bonded to a metal increases and it is difficult to obtain the ohmic contact as well as to lower the contact resistance. According to the invention, it is possible to obtain an excellent effect even in the case of the n-type group III nitride single crystal layer which contains a group III nitride single crystal layer containing Al at a high content rate and from which a favorable contact resistance value is hardly obtained in the prior art.

Hence, in the invention, the method is particularly suitably applied to the case of the n-type semiconductor layer containing a group III nitride single crystal containing Al in a large amount. Specifically, the method can be suitably applied to a case that the n-type group III nitride single crystal layer 2 contains a group III nitride single crystal satisfying the composition represented by AlxInyGazN (x, y, z are rational numbers satisfying 0 < x ≤ 1.0, 0 ≤ y ≤ 0.1, and 0 ≤ z < 1.0 and preferably 0.5 ≤ x ≤ 1.0, 0 ≤ y ≤ 0. 1, and 0 ≤ z ≤ 0.5, and x + y + z = 1.0.). The method of the invention is particularly suitably applied to the case of an n-type group III nitride single crystal layer containing a group III nitride single crystal in which x is preferably 0.5 or more and x is particularly preferably 0.6 or more among the group III nitride single crystals containing Al in a large amount. In this case, y may be 0 or more and 0.1 or less, but y is particularly preferably 0. Incidentally, the refractive index of the n-type group III nitride single crystal layer is from 1.5 to 3.0 although it is not particularly limited. The refractive index can be adjusted by the composition of the n-type group III nitride single crystal layer and the like.

### (n-type electrode)

The invention relates to the n-type electrode 5 to be formed on the n-type group III nitride single crystal layer 2. Moreover, the n-type electrode 5 includes a first electrode layer 3b and a second electrode layer 4b formed on the first electrode layer 3b, and at least the first electrode layer 3b contains nitrogen atoms and oxygen atoms. Moreover, in the first electrode layer 3b, the atomic ratio ([O]/[N]) of oxygen atoms to nitrogen atoms is 0.2 or more and 2.0 or less. Although it is a presumption, when the first electrode layer 3b contains oxygen atoms, it is possible to suppress the detachment of atoms from the n-type group III nitride single crystal layer 2 at the time of the heat treatment for forming the n-type electrode and to prevent the damaged layer 2b from being thickened. As a result, it is possible to manufacture an n-type laminated structure having a thin damaged layer 2b and a low contact resistance value (Fig. 1(e)). Incidentally, the atomic ratio of oxygen atoms to nitrogen atoms in the first electrode layer 3b is calculated by the method described in the following Examples.

In the first electrode layer 3b of the n-type electrode 5 of the invention, when the atomic ratio of oxygen atoms to nitrogen atoms is less than 0.2, the damaged layer 2b (a portion at which a change in composition due to detachment of a part of atoms constituting the single crystal is observed. See Fig. 3) is thickened which is generated at the time of the heat treatment performed for the purpose of improving the bonding property of the n-type electrode, alloying, and lowering the contact resistance value, so that the effect of thinning the damaged layer tends to decrease, and the contact resistance value increases. On the other hand, when the atomic ratio of oxygen atoms to nitrogen atoms is more than 2.0, the properties as an oxide film are emphasized, and the bonding property and conductivity of the n-type electrode deteriorate. In the first electrode layer 3b of the n-type electrode 5, the atomic ratio of oxygen atoms to nitrogen atoms is more preferably 0.5 or more and 2.0 or less and still more preferably 1.5 or more and 2.0 or less when the contact resistance value, bonding property, conductivity, and the like are taken into consideration. It is preferable that nitrogen atoms are contained in a form of a nitride with a metal which forms the n-type electrode. In addition, it is preferable that oxygen atoms are contained in a form of an oxide in the same manner as of the nitrogen.

(Suitable n-type electrode first electrode layer/second electrode layer) The configuration of the n-type electrode 5 can be a known configuration as long as the oxygen atoms are contained in the above range. Among these, a configuration in which the n-type electrode includes the first electrode layer 3b to be formed on the n-type group III nitride single crystal layer and the second electrode layer 4b formed on the first electrode layer 3b and at least the first electrode layer contains oxygen atoms, is adopted (see Fig. 1). In other words, it is possible to efficiently reduce the thickness of the damaged layer 2b of the n-type group III nitride single crystal layer 2 and to lower the contact resistance by forming the first electrode layer 3b having favorable bonding property with the n-type group III nitride single crystal layer 2 and containing oxygen atoms in the above range (a range in which the atomic ratio of oxygen atoms to nitrogen atoms is 0.2 or more and 2 or less).

### (First electrode layer)

It is preferable that this first electrode layer 3b is a nitride of at least one metal selected from the group consisting of Ti, V, and Ta. This nitride layer has [O]/[N] ratio in the above range and can be said so-called oxynitride. The above metals have common properties of exhibiting activity to a group III nitride containing Al and of reacting at high temperature to form a nitride. Hence, a layer (reaction layer) containing a nitride of the metal such as titanium nitride (TiN), vanadium nitride (VN), or tantalum nitride (TaN) or a composite nitride of the metals and Al is formed at the interface between the first electrode layer 3b and the n-type group III nitride single crystal layer 2 (or the damaged layer 2b when it exists) by a heat treatment described in detail below. Moreover, it is considered that the electron depletion layer is thinned (the width of the Schottky barrier is narrowed), so that an interface state exhibiting a tunnel effect is formed, and the contact resistance value can be lowered by having this reaction layer.

Furthermore, in the invention, the first electrode layer 3b contains oxygen atoms. In this first electrode layer 3b, the atomic ratio of oxygen atoms to nitrogen atoms is 0.2 or more and 2.0 or less, and it is more preferably 0.5 or more and 2.0 or less and still more preferably 1.5 or more and 2.0 or less.

The first electrode layer 3b is most preferably TiN when the balance with the second electrode layer 4b described later is taken into consideration. In addition, the thickness of the first electrode layer 3b is not particularly limited but it is preferably 1 nm or more and 50 nm or less.

Incidentally, in Examples of the invention described later, embodiments in which the first electrode layer 3b is fabricated using Ti are exemplified, but it is considered from the similarity described in "JOURNAL OF ELECTRONIC MATERIALS, Vol. 37, No. 5, 2008", and "JOURNAL OF APPLIED PHYSICS 100, 046106 (2006)" that the same effect is obtained even in the case of using V or Ta as well.

### (Second electrode layer)

In the invention, it is preferable that the second electrode layer 4b formed on the first electrode layer 3b contains a metal having a work function of from 4.0 eV to 4.8 eV and a specific resistance of from 1.5 × 10⁻⁶ Ω·cm to 4.0 × 10⁻⁶ Ω·cm (hereinafter simply referred to as the "high conductive metal" in some cases). In general, the work function of a metal is slightly different depending on the measurement method and the source of reference in some cases, but in the invention, it refers to the work function described in JOURNAL OF APPLIED PHYSICS, 48, 4729 (1977). The contact resistance can be lowered without increasing the Schottky barrier of the second electrode layer 4b by using the high conductive metal. The second electrode layer 4b can also contain nitrogen atoms and oxygen atoms. However, it is preferable that the second electrode layer 4b does not contain nitrogen atom and oxygen atom in order to further lower the contact resistance value.

Examples of the high conductive metal may include Al (specific resistance: 2.65 × 10⁻⁶ Ω·cm, work function: 4.28 eV), Ag (specific resistance: 1.59 × 10⁻⁶ Ω·cm, work function: 4.26 eV), and Cu (specific resistance: 1.92 × 10⁻⁶ Ω·cm, work function: 4.65 eV), but it is preferable to use Al since a high effect is obtained at low cost.

The second electrode layer 4b may contain only a layer containing a high conductive metal (high conductive metal layer), but it is preferable to contain another metal. Specifically, for instance, it is preferable to contain at least one metal selected from the group consisting of Ti, V, and Ta as connecting improver, for the reason that the bonding property with the first electrode layer 3b is enhanced. In addition, it is preferable to contain a precious metal containing Au and/or Pt for the reason that it is possible to stably lower the contact resistance and to realize ohmic contact. In addition, it is also possible to contain Ni (specific resistance: 6.2 × 10⁻⁶ Ω·cm, work function: 5.15 eV) in order to prevent the diffusion of precious metal.

When the second electrode layer 4b contains a metal other than the high conductive metal, the other metal may exist in a state of being diffused in the second electrode layer. For example, a layer containing the metal of connecting improver (connecting metal layer), a layer containing the high conductive metal, and a layer containing the precious metal are not clearly distinguished from one another but the respective metals exist in a state of being diffused when a heat treatment is performed for forming the second electrode layer 4b, and it is described in detail below. As an example of a state in which the metals are diffused, the following laminated structure may be mentioned. Namely, on the first electrode layer 3b, when a connecting metal layer 41, a high conductive metal layer 42, and a precious metal layer 43 are deposited in this order and subjected to a heat treatment, the following diffusion layers are formed from the first electrode layer side.

A layer in which the first electrode layer 3b and the connecting metal are mixed/
a layer which contains almost of a high conductive metal and formed by diffusion and migration of the high conductive metal/
a layer which contains a precious metal, a high conductive metal, and a connecting metal and is formed by diffusion and migration of the precious metal are formed.

The thickness of the second electrode layer 4b is not particularly limited, and it may be 20 nm or more. The upper limit of the thickness of the second electrode layer 4b cannot be unconditionally limited since the optimum thickness varies depending on the kind of the constituent metal and the multilayer configuration, but it is usually 200 nm when the productivity and economic efficiency are taken into consideration. In the case of a multilayer configuration, it is preferable that the total thickness satisfies the above range.

Next, methods of manufacturing the n-type electrode 5 and the n-type laminated structure (Fig. 1(e)) of the invention will be described.

### (Preparation of n-type group III nitride single crystal layer)

The n-type group III nitride single crystal layer 2 can be manufactured by the method described above. It is preferable to perform the following surface treatment usually in the case of forming the n-type electrode 5 thereon. In the case of manufacturing a group III nitride semiconductor device, a p-type semiconductor layer is further deposited on the n-type group III nitride single crystal layer 2 on which an n-type electrode is formed. Thereafter, a part of this p-type semiconductor layer is removed by an etching treatment (for example, a dry etching treatment using a halogen-based gas such as a chlorine-based gas containing a chlorine atom or a fluorine-based gas containing a fluorine atom), a p-type contact electrode is formed on the remaining p-type semiconductor layer, and the n-type electrode 5 is formed on the n-type group III nitride single crystal layer 2 exposed by the etching treatment. The method of the invention can also be effectively applied to a case that the n-type electrode is formed on the n-type group III nitride single crystal layer 2 exposed by such a method. Furthermore, the method can also be effectively applied to a case that the n-type electrode is formed on an n-type group III nitride single crystal layer which has been subjected to the dry etching treatment and then a surface treatment using an acid solution or an alkali solution. As a matter of course, the method of the invention can also be effectively applied to a case that the n-type electrode is formed on the n-type group III nitride single crystal layer which has only been subjected to a surface treatment using an acid solution or an alkali solution without being subjected to the dry etching treatment. Incidentally, a so-called horizontal device has been exemplified in the above description, but the invention can also be applied to a vertical device. By the surface treatment, it is possible to remove the oxide film and the hydroxide film from the surface of the n-type group III nitride single crystal layer 2 or the deteriorated layer of the n-type group III nitride single crystal layer 2 generated by treatments such as dry etching and mechanical polishing. Next, this surface treatment will be described.

First, the method of a surface treatment using an acid solution will be specifically described. As the acid solution, a solution of an inorganic acid such as hydrochloric acid, hydrofluoric acid, or aqua regia and a solution of an organic acid such as boron trifluoride etherate can be used. These acid solutions have an action of removing natural oxide films and hydroxide films formed on the surface of the n-type group III nitride single crystal layer. The concentration and temperature of the acid solution, and treatment time (the time to be immersed in the acid solution) may be appropriately optimized depending on the chemicals to be used. Examples of the method of the surface treatment may include a method in which the substrate is immersed in the acid solution. As an example of a preferred embodiment, it is preferable to perform the surface treatment by immersing the n-type group III nitride single crystal layer in an inorganic acid solution having a concentration of 10 wt% or more and 40 wt% or less at temperature of 50°C or more and not more than the boiling point of the solution and preferably 70°C or more and 100°C or less for 1 minute or more and 20 minutes or less.

Next, the method of a surface treatment using an alkali solution will be described in detail. As the alkali solution, an inorganic alkali solution such as potassium hydroxide aqueous solution or sodium hydroxide aqueous solution and an organic alkali solution such tetramethylammonium hydroxide (TMAH) aqueous solution can be used. It is considered that an action of wet-etching the n-type group III nitride single crystal layer is exhibited in the case of using these alkali solutions. The concentration and temperature of the alkali solution, and treatment time (the time to be immersed in the alkali solution) may be appropriately optimized depending on the chemicals to be used. Examples of the method of the surface treatment may include a method in which the substrate is immersed in the alkali solution. As an example of a preferred embodiment, it is preferable to perform the surface treatment by immersing the n-type semiconductor layer containing a group III nitride single crystal in an inorganic alkali solution having a concentration of 10 wt% to 20 wt% at a temperature of 50°C or more and not more than the boiling point of the solution and preferably 70°C or more and 100°C or less for 1 minute or more and 20 minutes or less.

The method of the invention can be suitably applied to a case that the n-type electrode 5 is formed on the n-type group III nitride single crystal layer 2 subjected to a surface treatment as described above. Next, a method for manufacturing the n-type electrode 5 will be described.

### (Method for manufacturing n-type electrode)

The method for manufacturing the n-type electrode is not particularly limited as long as the n-type electrode is manufactured so that the first electrode layer 3b contains nitrogen atoms and oxygen atoms, and the atomic ratio of oxygen atoms to nitrogen atoms is 0.2 or more and 2.0 or less. However, it is preferable to adopt the following method in order to efficiently introduce nitrogen atoms and oxygen atoms into the first electrode layer 3b in the above range. Namely, it is preferable to adopt a method including a step of forming a metal layer to be the n-type electrode on the n-type group III nitride single crystal layer and then performing a heat treatment in a mixed gas atmosphere containing an oxygen gas and an inert gas. This method will be described below in detail. First, a metal layer to be the n-type electrode is deposited on the n-type group III nitride single crystal layer. It is preferable that the step of forming the metal layer to be the n-type electrode includes a step of forming a first metal layer on the n-type group III nitride single crystal layer, a step of forming a first electrode layer by performing a heat treatment in a mixed gas atmosphere containing an oxygen gas and an inert gas after the first metal layer is formed, and a step of forming a second electrode layer on the first electrode layer.

### (Heat treatment)

According to the invention, the heat treatment conditions are such that the first metal layer is treated (by still standing) at a temperature of 800°C or more and 1200°C or less in a mixed gas atmosphere which contains an oxygen gas and an inert gas, and has a proportion of oxygen gas of from 0.1 to 10 vol% (provided that the total volume of an oxygen gas and an inert gas is set to 100 vol%). The inert gas is not particularly limited, but examples thereof may include an argon gas, a helium gas, and a nitrogen gas, and a nitrogen gas is particularly preferable. Incidentally, the volume proportion of oxygen gas is that at 25°C. The same applies hereinafter.

It is possible to efficiently form the n-type electrode 5 containing oxygen atoms in the desired amount when the proportion of oxygen gas is from 0.1 to 10 vol%. In addition, it is difficult to form a metal nitride layer (a reaction layer of the metal with the n-type layer) which has an effect of diminishing the Schottky barrier when the temperature in the mixed gas atmosphere is less than 800°C. On the other hand, decomposition of the n-type layer is likely to proceed when the temperature is more than 1200°C.

Such a heat treatment can be performed by using a rapid thermal annealing (RTA) apparatus which is usually used for forming an n-type electrode. The time of the heat treatment may be appropriately determined depending on the composition of the n-type group III nitride single crystal layer 2, the kind and thickness of a first metal layer 3, and the like, but it is preferable to perform the heat treatment for 30 seconds or more and 90 seconds or less. The time of the heat treatment does not include the time of the temperature rising process. It is preferable that the temperature rising time is as short as possible, but usually the temperature rising time is preferably 120 seconds or less and more preferably 60 seconds or less since it is affected by the volume and performance of the apparatus, the heat treatment temperature, and the like. The shortest time of the temperature rising time cannot be unconditionally limited since it is greatly affected by the performance of the apparatus, but it is usually 10 seconds. Under such conditions, the proportion of oxygen gas may be set to from 0.1 to 10 vol% and the proportion of inert gas may be set to from 90 to 99.9 vol% (sum of oxygen gas and nitrogen gas: 100 vol%).

In this heat treatment, the temperature may be a constant temperature or may fluctuate in the above range as long as the temperature is in the above range.

In the invention, it is preferable to manufacture the n-type electrode by including the following steps in order to efficiently introduce nitrogen atoms and oxygen atoms in the n-type electrode 5. Specifically, it is preferable that the step of forming a metal layer to be the n-type electrode 5 includes a step of forming a first metal layer 3 containing at least one metal selected from the group consisting of Ti, V and Ta on the n-type group III nitride single crystal layer 2, a step of forming a first electrode layer 3b by heat treatment in a mixed gas atmosphere containing an oxygen gas and a nitrogen gas after the first metal layer 3 is formed, and a step of forming a second electrode layer 4b on the first electrode layer 3b. By including such steps, it is possible to easily introduce nitrogen atoms and oxygen atoms at desired proportions in the n-type electrode. These steps of a preferred manufacturing method are illustrated in Fig. 1. Next, this preferred method will be described.

### (Suitable method for forming first electrode layer 3b)

### (Step of forming first metal layer 3 in Figs. 1(a) and (b))

In the invention, first, it is preferable to form the first metal layer 3 containing at least one metal selected from the group consisting of Ti, V and Ta on the n-type group III nitride single crystal layer 2.

As a method for depositing the first metal layer 3, a known method may be adopted. Examples of the specific method may include a method in which a metal film is deposited on the surface of the n-type group III nitride single crystal layer 2 by an electron-beam vacuum deposition method. The pressure in the chamber at the time of deposition of the metal film is preferably 1.0 × 10⁻³ Pa or less in order to decrease the influence of impurities and the like.

The thickness of the first metal layer 3 is not particularly limited, but it may be determined so that the thickness of the first electrode layer 3b is from 1 to 100 nm. There was no change in the thicknesses of the first metal layer 3 and the first electrode layer 3b when only the first electrode layer 3b was fabricated and observed. Hence, it is preferable to set the thickness of the first metal layer 3 to from 1 to 100 nm.

Moreover, the most suitable method of the invention includes a step of forming the first electrode layer 3b by forming the first metal layer 3 containing at least one metal selected from the group consisting of Ti, V and Ta and then performing a heat treatment (first heat treatment) in a mixed gas atmosphere containing an oxygen gas and an inert gas.

### (Heat treatment (first heat treatment) in mixed gas atmosphere "Fig. 1; first heat treatment")

In the invention, it is easy to introduce oxygen atoms and nitrogen atoms in the first electrode layer 3b when the first metal layer 3 is converted into the first electrode layer 3b by performing a heat treatment in a mixed gas atmosphere containing an oxygen gas and a nitrogen gas after the first metal layer 3 is deposited on the n-type group III nitride single crystal layer 2.

As described above, at least one metal selected from the group consisting of Ti, V and Ta reacts with the n-type group III nitride single crystal layer 2 to form a metal nitride layer (for example, TiN) and thereby forming the first electrode layer 3b containing nitrogen atoms. By performing the heat treatment (first heat treatment) in a mixed gas atmosphere containing an oxygen gas and a nitrogen gas, oxygen atoms are introduced into the first electrode layer 3b. Moreover, although it is a presumption, it is possible to reduce the thickness of the damaged layer 2b generated at the time of the this heat treatment and the heat treatment when forming the second electrode layer 4b to be described in detail below. Hence, it is considered that it is possible to suppress the detachment of atoms from the n-type group III nitride single crystal layer 2 likely occurring at the time of the heat treatment for forming the first and second electrode layers by introducing oxygen atoms in the first electrode layer 3b when forming the first electrode layer 3b. As a result, it is possible to efficiently reduce the thickness of the damaged layer 2b of the n-type group III nitride single crystal layer 2 and to lower the contact resistance value of the n-type laminated structure. The second electrode layer 4b may contain oxygen atoms since it is possible to suppress the detachment of atoms (it is considered that atoms move to the electrode side) from the n-type group III nitride single crystal layer 2 by forming a layer containing oxygen atoms, but it is preferable that the first electrode layer 3b contains oxygen atoms for the above reason.

### According to the invention, the conditions of the heat treatment (first heat treatment) in the mixed gas are such that the first metal layer is treated (by still standing) at a temperature of 800°C or more and 1200°C or less in a mixed gas atmosphere which contains an oxygen gas and an inert gas, and has a proportion of oxygen gas of from 0.1 to 10 vol% (provided that the total volume of an oxygen gas and an inert gas is set to 100 vol%) as described above. The inert gas is not particularly limited, but examples thereof may include an argon gas, a helium gas, and a nitrogen gas, and a nitrogen gas is particularly preferable.

It is possible to efficiently form the first electrode layer 3b containing oxygen atoms in the desired amount when the proportion of oxygen gas is from 0.1 to 10 vol%. In addition, it is difficult to form a metal nitride layer (a reaction layer of a metal with an n-type layer) which has an effect of diminishing the Schottky barrier when the temperature in the mixed gas atmosphere is less than 800°C. On the other hand, decomposition of the n-type layer tends to proceed when the temperature is more than 1200°C.

The oxidation (oxygen introduction) of the first electrode layer 3b tends to proceed more than necessary when the proportion of oxygen gas is more than 10 vol%. As described above, a metal oxide leads to a decrease in contact resistance since it can suppress the detachment of atoms from the n-type group III nitride single crystal layer 2 occurring at the time of the heat treatment, but a metal oxide leads to an increase in contact resistance when existing more than necessary since it intrinsically exhibits low conductivity. Namely, there is an optimum range for the content of metal oxide in order to lower the contact resistance, and it is preferable to set the proportion of oxygen gas to from 0.1 to 10 vol% in the mixed gas atmosphere at the time of the heat treatment in order to realize this range.

For such a first heat treatment, the same method as described in the heat treatment can be adopted. Specifically, the first heat treatment can be performed by using a rapid thermal annealing (RTA) apparatus which is usually used for forming an n-type electrode. The time of the first heat treatment may be appropriately determined depending on the composition of the n-type group III nitride single crystal layer 2, the kind and thickness of the first metal layer 3, and the like, but it is preferable to perform the first heat treatment for 30 seconds or more and 90 seconds or less. The time of the first heat treatment does not include the time of the temperature rising process. It is preferable that the temperature rising time is as short as possible, but usually the temperature rising time is preferably 120 seconds or less and still more preferably 60 seconds or less since it is affected by the volume and performance of the apparatus, the heat treatment temperature, and the like. The shortest time of the temperature rising time cannot be unconditionally limited since it is greatly affected by the performance of the apparatus, but it is usually 10 seconds. Under such conditions, the proportion of oxygen gas may be set to from 0.1 to 10 vol% and the proportion of inert gas may be set to from 90 to 99.9 vol% (sum of oxygen gas and nitrogen gas: 100 vol%).

In this first heat treatment, the temperature may be a constant temperature or may fluctuate in the above range as long as the temperature is in the above range. In addition, the comparison with the second heat treatment temperature may be performed by comparing the average values when the temperature fluctuates.

### (Method for forming second electrode layer 4b)

In the invention, the second electrode layer 4b may contain oxygen atoms. However, as described above, it is preferable that the second electrode layer 4b does not contain oxygen atom in order to obtain an n-type laminated structure exhibiting higher performance.

The second electrode layer 4b can be manufactured by a known method. For example, the same method as the method for forming a second layer in Patent Document 2 can be adopted. Specifically, it is preferable that the step of forming the second electrode layer 4b includes a step of forming the second metal layer 5 including the high conductive metal layer 42 containing a metal having a work function of from 4.0 eV to 4.8 eV and a specific resistance of from 1.5 × 10⁻⁶ Ω·cm to 4.0 × 10⁻⁶ Ω·cm on the first electrode layer 4b and a second heat treatment step of performing a heat treatment at a temperature of 700°C or more and 1000°C or less after the formation of the second metal layer 4. As the method for forming the second metal layer 4, the same method for forming the first metal layer 3 can be adopted although the kind of metal is different.

### (Step of forming second metal layer)

In the invention, it is preferable to form a high conductive metal layer containing a metal having a work function of from 4.0 eV to 4.8 eV and a specific resistance of from 1.5 × 10⁻⁶ Ω·cm to 4.0 × 10⁻⁶ Ω·cm on the first electrode layer 3b formed by the method described above.

As a method for depositing the second metal layer, a known method may be adopted. Examples of the specific method may include a method in which a metal film is deposited on the surface of the first electrode layer 3b by an electron-beam vacuum deposition method. The pressure in the chamber at the time of deposition of the metal film is preferably 1.0 × 10⁻³ Pa or less in order to decrease the influence of impurities and the like.

The thickness of the second metal layer is not particularly limited, but it may be determined so that the thickness of the second electrode layer is from 10 to 1000 nm. There was no change in the thicknesses of the second metal layer and the second electrode layer when various second electrode layers were fabricated by changing the thickness of the second metal layer. Hence, it is preferable to set the thickness of the second metal layer to from 10 to 1000 nm.

### (Second heat treatment)

In the invention, the temperature of the second heat treatment is preferably 700°C or more and 1000°C or less. It is possible to further lower the contact resistance value when this temperature range is satisfied. It is more preferable to set the temperature of the second heat treatment to 700°C or more and 850°C or less when considering the bonding property between the first electrode layer 3b and the second electrode layer 4b and the bonding property between the first electrode layer 3b and the n-type group III nitride single crystal layer 2. In addition, it is preferable to change this second heat treatment temperature depending on the method of the surface treatment subjected to the n-type group III nitride single crystal layer prior to forming the n-type electrode. Although the reason for this is not clear, it is considered that this is because the surface condition of the n-type group III nitride single crystal layer 2 varies depending on the method of the surface treatment. As a specific temperature condition, the temperature of the second heat treatment is set preferably to 740°C or more and 850°C or less and still more preferably to 750°C or more and 840°C or less when the surface treatment of the n-type group III nitride single crystal layer 2 is performed using an acid solution. On the other hand, the temperature of the second heat treatment is set preferably to 700°C or more and 850°C or less and still more preferably to 725°C or more and 800°C or less when the surface treatment is performed using an alkali solution.

In addition, it is preferable to set the temperature of the second heat treatment to be lower than the temperature of the first heat treatment in order to maintain strong adhesion between the first electrode layer 3b and the n-type group III nitride single crystal layer 2. Specifically, it is preferable to set the temperature of the second heat treatment to a temperature lower than that of the first heat treatment by 50°C or more. In addition, the upper limit of the difference in temperature between the first heat treatment and the second heat treatment is not particularly limited, but it is preferably 500°C or less and more preferably 250°C or less.

In this second heat treatment, the temperature may be a constant temperature or may fluctuate in the above range as long as the temperature is in the above range. In addition, the comparison with the first heat treatment temperature may be performed by comparing the average values when the temperature fluctuates.

### (Suitable method for forming second electrode layer "Fig. 1; second heat treatment from Fig. 1(d)")

According to the invention, the n-type electrode and the n-type laminated structure can be manufactured by the methods described above. However, it is preferable that the second metal layer is formed to have the following multilayer structure and then the second heat treatment is performed (see Fig. 1) in order to obtain the n-type electrode and the n-type laminated structure which exhibit higher performance.

Namely, it is preferable to include a connecting metal layer containing at least one metal selected from the group consisting of Ti, V, and Ta and it is still more preferable that the connecting metal layer is disposed as the lowermost layer of the multilayer structure, for the reason that the bonding property with the first electrode layer 3b is enhanced. In addition, it is preferable to include a precious metal layer containing Au and/or Pt and it is particularly preferable that the precious metal layer is disposed as the upper layer of the high conductive metal layer for the reason that it is possible to stably lower the contact resistance and to realize ohmic contact.

As the most preferred mode of the second metal layer 4, it is preferable to have a multilayer structure including the connecting metal layer 41, the high conductive metal layer 42, and the precious metal layer 43 laminated on the first electrode layer 3b in this order since the two effects described above can be obtained at the same time.

Namely, it is preferable that the step of forming the second metal layer 4 on the first electrode layer 3b includes a step of forming a connecting metal layer 41 containing at least one metal selected from the group consisting of Ti, V and Ta on the first electrode layer 3b,
a step of forming a high conductive metal layer 42 containing a metal having a work function of from 4.0 eV to 4.8 eV and a specific resistance of from 1.5 × 10⁻⁶ Ω·cm to 4.0 × 10⁻⁶ Ω·cm on the connecting metal layer 41, and a step of forming a precious metal layer 43 containing at least one precious metal selected from the group consisting of Au and Pt on the high conductive metal layer 42.

After such a multilayer structure is formed, the second heat treatment step is performed. A layer of Ni (specific resistance: 6.2 × 10⁻⁶ Ω·cm, work function: 5.15 eV) may be formed directly under the precious metal layer 43 in order to more reliably prevent the precious metal from diffusing and coming into contact with the n-type semiconductor layer without impairing the function of preventing void generation (filling the void) by controlling the diffusibility of the precious metal at the time of the second heat treatment.

When the second metal layer 4 has the multilayer structure, the thickness of the connecting metal layer 41 is preferably 5 nm or more and 20 nm or less, the thickness of the high conductive metal layer 42 is preferably 10 nm or more and 300 nm or less, and the thickness of the precious metal layer 43 is preferably 5 nm or more and 60 nm or less.

It is possible to form the second electrode layer 4b containing the connecting metal, the high conductive metal, and the precious metal by performing the second heat treatment after depositing the connecting metal layer 41, the high conductive metal layer 42 and the precious metal layer 43 on the first electrode layer 3b in this order.

### (Group III nitride semiconductor)

According to the method described above, the n-type electrode exhibiting favorable ohmic characteristics can be formed on the n-type group III nitride single crystal layer. The group III nitride semiconductor thus obtained can be driven at a low voltage and thus used in devices indispensably required to save energy such as LED devices.

### EXAMPLES

Hereinafter, the invention will be described in detail with reference to Examples, but the invention is not limited to the following Examples.

### Example 1

### (Preparation of n-type group III nitride single crystal layer)

An Al_{0.7}Ga_{0.3}N layer (1 µm) doped with Si at 1.0 × 10¹⁹ [cm⁻³] was formed on a c-plane AIN substrate (one side 7 mm square, 500 µm thick) as an n-type group III nitride single crystal layer by a MOCVD method.

### (Formation of first electrode layer)

### (Formation of first metal layer)

The surface of the n-type group III nitride single crystal layer was dry-etched using a chlorine-based gas. Thereafter, the substrate was immersed in hydrochloric acid having a concentration of 37 wt% at a temperature of 40°C for 15 minutes to perform the surface treatment of the Al_{0.7}Ga_{0.3}N layer. Next, a Ti (10 nm) layer was formed on the n-type group III nitride single crystal layer by vacuum deposition.

### (First heat treatment (heat treatment))

A first electrode layer was formed by subjecting the n-type group III nitride single crystal layer on which the first metal layer was formed to a heat treatment at 1000°C for 1 minute in a mixed gas atmosphere of 3 vol% oxygen gas/97 vol% nitrogen gas.

### (Formation of second electrode layer)

### (Formation of second metal layer; Formation of connecting metal layer/high conductive metal layer/precious metal layer)

Ti (10 nm)/AI (200 nm)/Au (5 nm) layers were formed on the first electrode layer in this order by vacuum deposition.

### (Second heat treatment)

Thereafter, a heat treatment was performed at 825°C for 1 minute in a nitrogen gas atmosphere, thereby forming an n-type electrode (n-type laminated structure).

(Characteristics of n-type electrode and n-type laminated structure) The characteristics of the n-type electrode and n-type laminated structure thus obtained were evaluated as follows.

### (Confirmation of thickness of damaged layer and composition of first electrode layer)

In order to obtain a thin slice sample for a transmission electron microscope (TEM), the n-type electrode (n-type laminated structure) was processed by using a FIB apparatus (SMI3050 manufactured by Seiko Instruments Inc.). First, the region of the n-type electrode was confirmed from the secondary ion microscope (SIM) image observed by using a FIB apparatus, and a carbon protective film was formed in the region using a phenanthrene gas. Thereafter, a piece of the n-type electrode-formed region was extracted by using a microprobing system equipped in the FIB apparatus. The extracted piece was fixed on a nanomesh for TEM observation (manufactured by SII Nano Technology Inc.) and processed into a thin slice. The processing into a thin slice was performed by irradiating the extracted piece with a Ga ion at an acceleration voltage of 30 kV by using an FIB apparatus. In order to suppress damage to the sample, the objective aperture was adjusted so that the beam current value did not exceed 3 nA, and the extracted piece was thinned until the slice thickness became approximately 100 nm. In this manner, a thin slice sample of the n-type electrode (n-type laminated structure) was fabricated. The thin slice sample thus obtained was subjected to the HAADF image observation by the STEM function mounted on a TEM apparatus (Tecnai F20 manufactured by FEI) to measure the thickness of the damaged layer, and also the oxygen atoms and nitrogen atoms in the first electrode layer were confirmed by the energy dispersive X-ray spectroscopic (EDS) analysis function mounted on the TEM apparatus.

In the STEM-HAADF image, contrast according to the atomic number and density of the elements in the sample is obtained, and it is more darkly observed as the constituent elements are lighter and sparser. A decrease in the X-ray intensities of Al and Ga was confirmed in the dark region when the darkly observed region in the vicinity of the surface of the n-type group III nitride single crystal layer was compared with the brightly observed region apart from the surface by EDS analysis. Hence, the darkly observed region on the surface of the n-type group III nitride single crystal layer was taken as the damaged layer and the thickness thereof was measured. As a result, the thickness was 20.7 µm. In addition, the EDS spectrum was subjected to peak fitting by setting the peak/background ratio to 3 and removing the background. As a result of quantitative calculation for the spectrum subjected to these treatments, the atomic ratio of oxygen atoms to nitrogen atoms in the first electrode layer was 0.66. The above treatments were all performed using TEM Imaging & Analysis manufactured by FEI. In addition, in the n-type laminated structure obtained, the voltage at the time applying electric current of 1 mA was measured and found to be 4.9 V. These results are summarized in Table 1.

### Example 2

An n-type electrode and an n-type laminated structure were manufactured by the same method as in Example 1 except that the oxygen concentration at the time of the first heat treatment was changed and the heat treatment was performed in a mixed gas atmosphere of 10 vol% oxygen gas and 90 vol% nitrogen gas in Example 1. In addition, the n-type electrode and n-type laminated structure thus obtained were evaluated by the same method as in Example 1. As illustrated in Fig. 2, the damaged layer was 16.0 nm to be extremely thin.

### Comparative Example 1

An n-type electrode and an n-type laminated structure were manufactured by the same method as in Example 1 except that the oxygen concentration at the time of the first heat treatment was changed and the heat treatment was performed in a nitrogen gas atmosphere in Example 1. In addition, the n-type electrode and n-type laminated structure thus obtained were evaluated by the same method as in Example 1. As illustrated in Fig. 3, the damaged layer was 26.8 nm to be thick and electrical characteristics deteriorated.

**[Table 1]**

| | Atmosphere for first heat treatment | Atomic ratio of oxygen atom to nitrogen atom in first electrode layer [O]/[N] | Thickness of damaged layer [nm] | Electrical characteristics (voltage at time of applying electric current of 1 mA) [V] |
|---|---|---|---|---|
| Comparative Example 1 | Nitrogen gas | 0.18 | 26.8 | 10.5 |
| Example 1 | Mixed atmosphere of 3 vol% oxygen gas and 97 vol% nitrogen gas | 0.66 | 20.7 | 4.9 |
| Example 2 | Mixed atmosphere of 10 vol% oxygen gas and 90 vol% nitrogen gas | 1.76 | 16.0 | 1.7 |

### EXPLANATIONS OF LETTERS OR NUMERALS

- 1: Substrate
- 2: n-Type Group III Nitride Single Crystal Layer
- 2b: Damaged Layer
- 3: First Metal Layer
- 3b: First Electrode Layer
- 4: Second Metal Layer
- 41: Connecting Metal Layer
- 42: High Conductive Metal Layer
- 43: Precious Metal Layer
- 4b: Second Electrode Layer
- 5: n-Type Electrode

## Claims

1. An n-type electrode (5) to be formed on an n-type group III nitride single crystal layer (2), the n-type electrode (5) comprising a first electrode layer (3b) to be formed on the n-type group III nitride single crystal layer (2) and a second electrode layer (4b) formed on the first electrode layer (3b),
wherein at least the first electrode layer (3b) contains nitrogen atoms and oxygen atoms,
**characterized in that**
an atomic ratio of the oxygen atoms to the nitrogen atoms is 0.2 or more and 2.0 or less.

2. The n-type electrode (5) according to claim 1, wherein
the first electrode layer (3b) is a nitride of at least one metal selected from the group consisting of Ti, V and Ta, and
the second electrode layer (4b) contains a metal having a work function of from 4.0 eV to 4.8 eV and a specific resistance of from 1.5 × 10⁻⁶ Ω·cm to 4.0 × 10⁻⁶ Ω·cm.

3. The n-type electrode (5) according to claim 2, wherein
the second electrode layer (4b) further contains at least one metal selected from the group consisting of Ti, V and Ta and at least one precious metal selected from the group consisting of Au and Pt.

4. An n-type laminated structure comprising the n-type electrode (5) according to any one of claims 1 to 3 on an n-type nitride single crystal layer (2).

5. The n-type laminated structure according to claim 4, wherein the n-type nitride single crystal layer (2) contains a group III nitride single crystal satisfying composition represented by AlxInyGazN, whereby x, y, z are rational numbers satisfying 0 < x ≤ 1.0, 0 ≤ y ≤ 0.1, and 0 ≤ z < 1.0, and x + y + z = 1.0.

6. A method for forming an n-type electrode (5) on an n-type group III nitride single crystal layer (2), comprising
a step of forming a metal layer to be the n-type electrode including
a step of forming a first metal layer (3) on the n-type group III nitride single crystal layer (2),
a step of forming a first electrode layer (3b) by performing a heat treatment in a mixed gas atmosphere containing an oxygen gas and an inert gas after formation of the first metal layer (3), and
a step of forming a second electrode layer (4b) on the first electrode layer (3b),
**characterized in that** the heat treatment performed after formation of the first metal layer (3) in the step of forming the first electrode layer (3b) is a first heat treatment step of performing a heat treatment at a temperature of 800°C or more and 1200°C or less in a mixed gas atmosphere having a proportion of oxygen gas of from 0.1 to 10 vol%.

7. The method for forming the n-type electrode (5) according to claim 6, wherein the step of forming the first metal layer (3) is a step of forming a first metal layer (3) containing at least one metal selected from the group consisting of Ti, V and Ta on the n-type group III nitride single crystal layer (2).

8. The method for forming the n-type electrode (5) according to claim 6 or 7, wherein the step of forming the second electrode layer (4b) includes
a step of forming a second metal layer (4) including a high conductive metal layer (42) containing a metal having a work function of from 4.0 eV to 4.8 eV and a specific resistance of from 1.5 × 10⁻⁶ Ω·cm to 4.0 × 10⁻⁶ Ω·cm on the first electrode layer (3b), and
a second heat treatment step of performing a heat treatment at a temperature of 700°C or more and 1000°C or less after formation of the second metal layer (4).

9. The method for forming the n-type electrode (5) according to claim 8, wherein the step of forming the second metal layer (4) on the first electrode layer (3b) includes
a step of forming a connecting metal layer (41) containing at least one metal selected from the group consisting of Ti, V and Ta on the first electrode layer (3b),
a step of forming a high conductive metal layer (42) containing a metal having a work function of from 4.0 eV to 4.8 eV and a specific resistance of from 1.5 × 10⁻⁶ Ω·cm to 4.0 × 10⁻⁶ Ω·cm on the connecting metal layer (41), and
a step of forming a precious metal layer (43) containing at least one precious metal selected from the group consisting of Au and Pt on the high conductive metal layer (42).

## Patentansprüche

1. n-Typ-Elektrode (5), auszubilden auf einer n-Typ-Gruppe-III-Nitrid-Einkristallschicht (2), wobei die n-Typ-Elektrode (5) eine auf der n-Typ-Gruppe-III-Nitrid-Einkristallschicht (2) auszubildende erste Elektrodenschicht (3b) und eine auf der ersten Elektrodenschicht (3b) ausgebildete zweite Elektrodenschicht (4b) umfasst,
wobei mindestens die erste Elektrodenschicht (3b) Stickstoffatome und Sauerstoffatome enthält,
**dadurch gekennzeichnet, dass**
ein Atomverhältnis der Sauerstoffatome zu den Stickstoffatomen 0,2 oder mehr und 2,0 oder weniger beträgt.

2. n-Typ-Elektrode (5) nach Anspruch 1, wobei
die erste Elektrodenschicht (3b) ein Nitrid von mindestens einem Metall ist, das aus der aus Ti, V und Ta bestehenden Gruppe gewählt ist, und
die zweite Elektrodenschicht (4b) ein Metall mit einer Austrittsenergie von 4,0 eV bis 4,8 eV und einem spezifischen Widerstand von 1,5 × 10⁻⁶ Ω·cm bis 4,0 × 10⁻⁶ Ω·cm enthält.

3. n-Typ-Elektrode (5) nach Anspruch 2, wobei
die zweite Elektrodenschicht (4b) ferner mindestens ein Metall, das gewählt ist aus der aus Ti, V und Ta bestehenden Gruppe, und mindestens ein Edelmetall, das gewählt ist aus der aus Au und Pt bestehenden Gruppe, enthält.

4. n-Typ-laminierte Struktur, umfassend die n-Typ-Elektrode (5) gemäß einem beliebigen der Ansprüche 1 bis 3 auf einer n-Typ-Nitrid-Einkristallschicht (2).

5. n-Typ-laminierte Struktur nach Anspruch 4, wobei die n-Typ-Nitrid-Einkristallschicht (2) eine Gruppe-III-Nitrid-Einkristallschicht enthält, die eine durch AlₓIn_{y}Ga_{z}N dargestellte Zusammensetzung erfüllt, wobei x, y, z rationale Zahlen sind, die 0 < x ≤ 1,0, 0 ≤ y ≤ 0,1 und 0 ≤ z < 1,0 sowie x + y + z = 1,0 erfüllen.

6. Verfahren zum Ausbilden einer n-Typ-Elektrode (5) auf einer n-Typ-Gruppe-III-Nitrid-Einkristallschicht (2), umfassend
einen Schritt des Ausbildens einer Metallschicht als die n-Typ-Elektrode, enthaltend
einen Schritt des Ausbildens einer ersten Metallschicht (3) auf der n-Typ-Gruppe-III-Nitrid-Einkristallschicht (2),
einen Schritt des Ausbildens einer ersten Elektrodenschicht (3b) durch ein Durchführen einer Wärmebehandlung in einer Mischgasatmosphäre, enthaltend ein Sauerstoffgas und ein Inertgas, nach dem Ausbilden der ersten Metallschicht (3), und
einen Schritt des Ausbildens einer zweiten Elektrodenschicht (4b) auf der ersten Elektrodenschicht (3b),
**dadurch gekennzeichnet, dass** die Wärmebehandlung, die nach dem Ausbilden der ersten Metallschicht (3) in dem Schritt des Ausbildens der ersten Elektrodenschicht (3b) durchgeführt wird, ein erster Wärmebehandlungsschritt des Durchführens einer Wärmebehandlung bei einer Temperatur von 800 °C oder mehr und 1200 °C oder weniger in einer Mischgasatmosphäre mit einem Volumenanteil an Sauerstoffgas von 0,1 bis 10 % ist.

7. Verfahren zum Ausbilden der n-Typ-Elektrode (5) nach Anspruch 6, wobei der Schritt des Ausbildens der ersten Metallschicht (3) ein Schritt des Ausbildens einer ersten Metallschicht (3) ist, enthaltend mindestens ein Metall, gewählt aus der aus Ti, V und Ta bestehenden Gruppe, auf der n-Typ-Gruppe-III-Nitrid-Einkristallschicht (2).

8. Verfahren zum Ausbilden der n-Typ-Elektrode (5) nach Anspruch 6 oder 7, wobei der Schritt des Ausbildens der zweiten Elektrodenschicht (4b) enthält
einen Schritt des Ausbildens einer zweiten Metallschicht (4), enthaltend eine hoch leitfähige Metallschicht (42), enthaltend ein Metall mit einer Austrittsenergie von 4,0 eV bis 4,8 eV und einem spezifischen Widerstand von 1,5 × 10⁻⁶ Ω·cm bis 4,0 × 10⁻⁶ Ω·cm auf der ersten Elektrodenschicht (3b), und
einen zweiten Wärmebehandlungsschritt des Durchführens einer Wärmebehandlung bei einer Temperatur von 700 °C oder mehr und 1000 °C oder weniger nach dem Ausbilden der zweiten Metallschicht (4).

9. Verfahren zum Ausbilden der n-Typ-Elektrode (5) nach Anspruch 8, wobei der Schritt des Ausbildens der zweiten Metallschicht (4) auf der ersten Elektrodenschicht (3b) enthält
einen Schritt des Ausbildens einer Verbindungs-Metallschicht (41), enthaltend mindestens ein Metall, gewählt aus der aus Ti, V und Ta bestehenden Gruppe, auf der ersten Elektrodenschicht (3b),
einen Schritt des Ausbildens einer hoch leitfähigen Metallschicht (42), enthaltend ein Metall mit einer Austrittsenergie von 4,0 eV bis 4,8 eV und einem spezifischen Widerstand von 1,5 × 10⁻⁶ Ω·cm bis 4,0 × 10⁻⁶ Ω·cm auf der Verbindungs-Metallschicht (41), und
einen Schritt des Ausbildens einer Edelmetallschicht (43), enthaltend mindestens ein aus der aus Au und Pt bestehenden Gruppe gewähltes Edelmetall, auf der hoch leitfähigen Metallschicht (42).

## Revendications

1. Électrode de type N (5) devant être formée sur une couche monocristalline de nitrure du groupe III de type N (2), l'électrode de type N (5) comprenant une première couche d'électrode (3b) devant être formée sur la couche monocristalline de nitrure du groupe III de type N (2) et une deuxième couche d'électrode (4b) formée sur la première couche d'électrode (3b),
dans laquelle au moins la première couche d'électrode (3b) contient des atomes d'azote et des atomes d'oxygène,
**caractérisée en ce que**
un rapport atomique des atomes d'oxygène aux atomes d'azote est de 0,2 ou plus et de 2,0 ou moins.

2. Électrode de type N (5) selon la revendication 1, dans laquelle
la première couche d'électrode (3b) est un nitrure d'au moins un métal choisi dans le groupe constitué par Ti, V et Ta, et
la deuxième couche d'électrode (4b) contient un métal ayant une fonction de travail de 4,0 eV à 4,8 eV et une résistance spécifique de 1,5 × 10⁻⁶ Ω·cm à 4,0 × 10⁻⁶ Ω·cm.

3. Électrode de type N (5) selon la revendication 2, dans laquelle
la deuxième couche d'électrode (4b) contient en outre au moins un métal choisi dans le groupe constitué par Ti, V et Ta et au moins un métal précieux choisi dans le groupe constitué par Au et Pt.

4. Structure feuilletée de type N comprenant l'électrode de type N (5) selon l'une quelconque des revendications 1 à 3 sur une couche monocristalline de nitrure de type N (2).

5. Structure feuilletée de type N selon la revendication 4, dans laquelle la couche monocristalline de nitrure de type N (2) contient un monocristal de nitrure du groupe III satisfaisant à la composition représentée par AlₓIn_{y}Ga_{z}N, sachant que x, y, z sont des nombres rationnels satisfaisant à 0 < x ≤ 1,0, 0 ≤ y ≤ 0,1 et0 ≤ z < 1,0 et x + y + z = 1,0.

6. Procédé pour former une électrode de type N (5) sur une couche monocristalline de nitrure du groupe III de type N (2), comprenant
une étape consistant à former une couche métallique destinée à être l'électrode de type N comprenant
une étape consistant à former une première couche métallique (3) sur la couche monocristalline de nitrure du groupe III de type N (2),
une étape consistant à former une première couche d'électrode (3b) en effectuant un traitement thermique dans une atmosphère à gaz mixte contenant un gaz d'oxygène et un gaz inerte après la formation de la première couche métallique (3), et
une étape consistant à former une deuxième couche
d'électrode (4b) sur la première couche d'électrode (3b), **caractérisé en ce que** le traitement thermique effectué après la formation de la première couche métallique (3) à l'étape consistant à former la première couche d'électrode (3b) est une première étape de traitement thermique consistant à effectuer un traitement thermique à une température de 800 °C ou plus et de 1 200 °CC ou moins dans une atmosphère de gaz mixte ayant une proportion de gaz d'oxygène de 0,1 à 10 % en volume.

7. Procédé pour former l'électrode de type N (5) selon la revendication 6, dans lequel l'étape consistant à former la première couche métallique (3) est une étape consistant à former une première couche métallique (3) contenant au moins un métal choisi dans le groupe constitué de Ti, V et Ta sur la couche monocristalline de nitrure du groupe III de type N (2).

8. Procédé pour former l'électrode de type N (5) selon la revendication 6 ou 7, dans lequel l'étape consistant à former la deuxième couche d'électrode (4b) comprend
une étape consistant à former une deuxième couche métallique (4) comprenant une couche métallique hautement conductrice (42) contenant un métal ayant une fonction de travail de 4,0 eV à 4,8 eV et une résistance spécifique de 1,5 × 10⁻⁶ Ω·cm à 4,0 × 10⁻⁶ Ω·cm sur la première couche d'électrode (3b), et
une deuxième étape de traitement thermique consistant à effectuer un traitement thermique à une température de 700 °C ou plus et de 1 000 °C ou moins après la formation de la deuxième couche métallique (4).

9. Procédé pour former l'électrode de type N (5) selon la revendication 8, dans lequel l'étape consistant à former la deuxième couche métallique (4) sur la première couche d'électrode (3b) comprend
une étape consistant à former une couche métallique de connexion (41) contenant au moins un métal sélectionné dans le groupe constitué de Ti, V et Ta sur la première couche d'électrode (3b),
une étape consistant à former une couche métallique hautement conductrice (42) contenant un métal ayant une fonction de travail de 4,0 eV à 4,8 eV et une résistance spécifique de 1,5 × 10⁻⁶ Ω·cm à 4,0 × 10⁻⁶ Ω·cm sur la couche métallique de connexion (41), et
une étape consistant à former une couche de métal précieux (43) contenant au moins un métal précieux choisi dans le groupe constitué par Au et Pt sur la couche métallique hautement conductrice (42).
